# EUROPÄISCHE PATENTANMELDUNG

(11) **EP 4 432 344 A1**
(43) Veröffentlichungstag der Anmeldung: **18.09.2024**
(21) Anmeldenummer: 23162093.1
(22) Anmeldetag: 15.03.2023
(51) Int. Cl.: H01L 23/367, H01L 23/373, H01L 23/42, H01L 23/44, H01L 23/29

(54) **HALBLEITERANORDNUNG MIT EINEM HALBLEITERELEMENT UND EINEM SUBSTRAT**

(71) Anmelder: Siemens Aktiengesellschaft, 80333 München (DE)
(72) Erfinder: Kiesel, Alexander, 82467 Garmisch-Partenkirchen (DE); Kneißl, Philipp, 90427 Nürnberg (DE); Ochs, Ewgenij, 90765 Fürth (DE); Pfefferlein, Stefan, 90562 Heroldsberg (DE); Schwarz, Florian, 90766 Fürth (DE)
(74) Vertreter: Siemens Patent Attorneys

(57) **Zusammenfassung**

Die Erfindung betrifft eine Anordnung (2) mit einem elektronischen Bauelement (4) und einem Substrat (6). Um den Bauraum einer derartigen Anordnung (2) zu verringern und eine verbesserte Entwärmung zu ermöglichen, wird vorgeschlagen, dass das Substrat (6) eine Metallisierung (10) mit zumindest einer ersten Leiterstruktur (16) und einer zweiten Leiterstruktur (18) aufweist, wobei die erste Leiterstruktur (16) zumindest teilweise innerhalb der zweiten Leiterstruktur (18) angeordnet ist, wobei das elektronische Bauelement (4), insbesondere stoffschlüssig, mit der ersten Leiterstruktur (16) verbunden ist, wobei das elektronische Bauelement (4) von einem thermisch leitfähigen Gehäuseelement (8) umgeben ist, welches stoffschlüssig mit der zweiten Leiterstruktur (18) verbunden ist, wobei eine Deckfläche (26) und zumindest eine Seitenfläche (28) des elektronischen Bauelements (4) über ein thermisch leitfähiges Füllmaterial (24) mit dem Gehäuseelement (8) verbunden ist.

## Beschreibung

Die Erfindung betrifft eine Anordnung mit einem elektronischen Bauelement und einem Substrat.

Ferner betrifft die Erfindung einen Stromrichter mit mindestens einer derartigen Anordnung.

Weiterhin betrifft die Erfindung ein Verfahren zur Herstellung einer Anordnung mit einem elektronischen Bauelement und einem Substrat.

Darüber hinaus betrifft die Erfindung eine Verwendung von Segmentstreifen mit Segmenten, welche jeweils eine Kavität aufweisen, zur Herstellung von Gehäuseelementen für eine derartige Anordnung.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. In einem Stromrichter können aktive elektronische Bauelemente wie Transistoren und Dioden sowie passive elektronische Bauelemente, z.B. Kondensatoren, Widerstände aber auch Sensoren, zum Einsatz kommen. Derartige elektronischen Bauelemente sind üblicherweise mit einem Substrat verbunden. Die elektrische Performance, insbesondere die Lebensdauer, der elektronischen Bauelemente hängt signifikant von deren thermischer Entwärmung ab. Für einen hohen Wärmestrom bzw. Wärmefluss spielt die Entwärmungszeit eine entscheidende Rolle. Mit einer Fluidkühlung sind zwar hohe Wärmeströme erreichbar, je nach Anwendung kann die Kühllösung jedoch sehr aufwändig werden. Ferner benötigen beispielsweise Wärmespreizplatten und Kühlkörper einen großen Bauraum.

Vor diesem Hintergrund ist es eine Aufgabe der vorliegenden Erfindung, den Bauraum einer derartigen Anordnung zu verringern und eine verbesserte Entwärmung zu ermöglichen.

Diese Aufgabe wird erfindungsgemäß gelöst durch eine Anordnung mit einem elektronischen Bauelement und einem Substrat, wobei das Substrat eine Metallisierung mit zumindest einer ersten Leiterstruktur und einer zweiten Leiterstruktur aufweist, wobei die erste Leiterstruktur zumindest teilweise innerhalb der zweiten Leiterstruktur angeordnet ist, wobei das elektronische Bauelement, insbesondere stoffschlüssig, mit der ersten Leiterstruktur verbunden ist, wobei das elektronische Bauelement von einem thermisch leitfähigen Gehäuseelement umgeben ist, welches stoffschlüssig mit der zweiten Leiterstruktur verbunden ist, wobei eine Deckfläche und zumindest eine Seitenfläche des elektronischen Bauelements über ein thermisch leitfähiges Füllmaterial mit dem Gehäuseelement verbunden ist.

Ferner wird die Aufgabe erfindungsgemäß gelöst durch einen Stromrichter mit mindestens einer derartigen Anordnung.

Weiterhin wird die Aufgabe erfindungsgemäß gelöst durch ein Verfahren zur Herstellung einer Anordnung mit einem elektronischen Bauelement und einem Substrat, wobei das Substrat eine Metallisierung mit zumindest einer ersten Leiterstruktur und einer zweiten Leiterstruktur aufweist, wobei die erste Leiterstruktur zumindest teilweise innerhalb der zweiten Leiterstruktur angeordnet ist, umfassend folgende Schritte: Einlegen des elektronischen Bauelements und eines thermisch leitfähigen Füllmaterials in ein thermisch leitfähiges Gehäuseelement, wobei eine Deckfläche und zumindest eine Seitenfläche des elektronischen Bauelements über das thermisch leitfähige Füllmaterial mit dem Gehäuseelement verbunden wird, Verbinden des elektronischen Bauelements mit der ersten Leiterstruktur und stoffschlüssiges Verbinden des Gehäuseelements mit der zweiten Leiterstruktur.

Überdies wird die Aufgabe erfindungsgemäß gelöst durch ein Verfahren zur Herstellung einer Anordnung mit einem elektronischen Bauelement und einem Substrat, wobei das Substrat eine Metallisierung mit zumindest einer ersten Leiterstruktur und einer zweiten Leiterstruktur aufweist, wobei die erste Leiterstruktur zumindest teilweise innerhalb der zweiten Leiterstruktur angeordnet ist, umfassend folgende Schritte: Verbinden des elektronischen Bauelements mit der ersten Leiterstruktur und stoffschlüssiges Verbinden eines thermisch leitfähigen Gehäuseelements mit der zweiten Leiterstruktur, Einfüllen eines thermisch leitfähigen fließfähigen Füllmaterials in das Gehäuseelement, wobei eine Deckfläche und zumindest eine Seitenfläche des elektronischen Bauelements über das Füllmaterial mit dem Gehäuseelement verbunden wird.

Darüber hinaus wird die Aufgabe erfindungsgemäß gelöst durch eine Verwendung von, insbesondere metallischen, Segmentstreifen mit Segmenten, welche jeweils eine Kavität aufweisen, zur Herstellung von Gehäuseelementen für eine derartige Anordnung, wobei die Segmentstreifen zwischen den Segmenten Sollbruchstellen, insbesondere mit einer Perforierung, aufweisen.

Die in Bezug auf die Anordnung nachstehend angeführten Vorteile und bevorzugten Ausgestaltungen lassen sich sinngemäß auf den Stromrichter, die Verfahren und die Verwendung übertragen.

Der Erfindung liegt die Überlegung zugrunde, die Entwärmung eines elektronischen Bauelements, welches auf einem Substrat verbunden ist, über einen zusätzlichen Wärmepfad zu verbessern. Neben der Entwärmung über das Substrat wird ein zusätzlicher Wärmepfad über ein thermisch leitfähiges Gehäuseelement geschaffen, welches das elektronische Bauelement umgibt. Das thermisch leitfähige Gehäuseelement kann unter anderem aus einem metallischen Werkstoff, z.B. Kupfer, Aluminium oder eine deren Legierungen, einem thermisch leitfähigen Kunststoff oder einem keramischen Werkstoff hergestellt sein. Eine thermische Verbindung des elektronischen Bauelements zum thermisch leitfähigen Gehäuseelement wird über ein thermisch leitfähiges Füllmaterial hergestellt, wobei eine Deckfläche und zumindest eine Seitenfläche des elektronischen Bauelements über das Füllmaterial mit dem Gehäuseelement verbunden sind. Beispielsweise weist das Gehäuseelement eine Gehäuseinnenwand auf, welche mit dem Füllmaterial verbunden ist. Das thermisch leitfähige Füllmaterial kann elektrisch isolierend oder elektrisch leitend ausgeführt sein.

Das Substrat weist eine Metallisierung mit zumindest einer ersten Leiterstruktur und einer zweiten Leiterstruktur auf, wobei die erste Leiterstruktur zumindest teilweise innerhalb der zweiten Leiterstruktur angeordnet ist. Beispielsweise umfasst die zweite Leiterstruktur eine Leiterbahn auf, welche eine Leiterbahn der ersten Leiterstruktur teilweise umgibt. Eine derartige Leiterbahn der zweiten Leiterstruktur kann unter anderem elliptisch, rund, rechteckig oder quadratisch um die erste Leiterstruktur herum verlaufend ausgeführt sein und zumindest eine Unterbrechung aufweisen. Insbesondere ist die zweite Leiterstruktur elektrisch isoliert von der ersten Leiterstruktur angeordnet. Das Substrat kann unter anderem als DCB (Direct Copper Bonded) Substrat ausgeführt sein. Das elektronische Bauelement ist, insbesondere stoffschlüssig, mit der ersten Leiterstruktur verbunden. Beispielsweise ist das elektronische Bauelement durch Löten, Sintern oder adhäsiv mit der ersten Leiterstruktur verbunden. Das thermisch leitfähige Gehäuseelement ist stoffschlüssig, z.B. durch Löten, Sintern oder adhäsiv, mit der zweiten Leiterstruktur verbunden. Alternativ kann Verbinden des elektronische Bauelements mit der ersten Leiterstruktur kraftschlüssig durch Anpressen, z.B. durch das Gehäuseelement, erfolgen. Durch eine derartige Anordnung, welche einen geringen Kontaktwiderstand aufweist, kann eine während des Betriebes des elektronischen Bauelements entstehende Verlustwärme zusätzlich über das thermisch leitfähige Füllmaterial und das thermisch leitfähige Gehäuseelement an das Substrat bzw. an die Umgebung abgegeben werden. Ferner wird durch das thermisch leitfähige Gehäuseelement und das thermisch leitfähige Füllmaterial Bauraum eingespart.

Eine weitere Ausführungsform sieht vor, dass das thermisch leitfähige Füllmaterial zumindest zum Zeitpunkt des Betriebs des elektronischen Bauelements fließfähig ist. Insbesondere ist das thermisch leitfähige Füllmaterial als Liquid ausgeführt. Daraus ergibt sich ein geringer Kontaktwiderstand und somit eine sehr gute Wärmeleitfähigkeit.

Eine weitere Ausführungsform sieht vor, dass das elektronische Bauelement durch das Gehäuseelement, insbesondere fluiddicht, gekapselt ist. Durch eine derartige Kapselung wird ein Austreten des thermisch leitfähigen Füllmaterials verhindert, sodass eine Wartung erleichtert und eine Lebensdauer erhöht wird. Ferner kann durch eine derartige gekapselte Anordnung auf weitere Gehäusekomponenten zumindest teilweise verzichtet werden, sodass zusätzlich Bauraum eingespart wird.

Eine weitere Ausführungsform sieht vor, dass das thermisch leitfähige Füllmaterial elektrisch isolierend ausgeführt ist. Insbesondere ist das thermisch leitfähige Füllmaterial als Inertflüssigkeit ausgeführt. Unter anderem kommen Galden^{®} HS 240, 3M^{™} Novec^{™} oder 3M^{™} Fluorinert^{™}, aber auch Paraffine infrage. Derartige Inertflüssigkeiten können eine hohe Durchschlagsfestigkeit von mindestens 10 kV/mm, insbesondere 20 kV/mm aufweisen. Ferner ergibt sich durch die Verwendung elektrisch isolierender Liquide ein geringer Kontaktwiderstand und eine sehr gute Wärmeleitfähigkeit.

Eine weitere Ausführungsform sieht vor, dass ein Zwischenraum zwischen dem elektronischen Bauelement und dem Gehäuseelement vollständig durch das thermisch leitfähige Füllmaterial ausgefüllt ist. Dadurch werden optimierte Isolationseigenschaften erreicht und es kann Bauraum eingespart werden. Ferner wird der Kontaktwiderstand reduziert, was zu einer verbesserten Wärmeabfuhr führt.

Eine weitere Ausführungsform sieht vor, dass das thermisch leitfähige Füllmaterial elektrisch leitfähig ausgeführt ist. Beispielsweise weist das thermisch leitfähige Füllmaterial ein Flüssigmetall auf. Das Flüssigmetall kann unter anderem Gallium und/oder Indium enthalten. Somit ist eine thermische Leitfähigkeit des Füllmaterial von mindestens 40 W/mK, insbesondere 60 W/mK, erreichbar.

Eine weitere Ausführungsform sieht vor, dass das Füllmaterial über einen elektrisch isolierenden Werkstoff von einem Kontaktierungsbereich des elektronischen Bauelements mit dem Substrat elektrisch isoliert angeordnet ist. Der elektrisch isolierende Werkstoff kann unter anderem Silikon oder ein Harz enthalten. Durch eine derartige Anordnung werden Kurzschlüsse verhindert, während eine hohe thermische Leitfähigkeit erreicht wird.

Eine weitere Ausführungsform sieht vor, dass der elektrisch isolierende Werkstoff zumindest Teil eines Abdichtelements ist. Beispielsweise ist das Abdichtelement insbesondere adhäsiv, mit einer Gehäuseinnenwand und Seitenflächen des elektronischen Bauelements verbunden. Insbesondere ist das Füllmaterial durch das Gehäuseelement und das Abdichtelement fluiddicht um das elektronische Bauelement herum gekapselt. Somit werden Kurzschlüsse verhindert, während eine hohe thermische Leitfähigkeit erreicht wird.

Eine weitere Ausführungsform sieht vor, dass das Gehäuseelement zumindest ein Distanzelement aufweist, welches mit dem elektronischen Bauelement kontaktiert ist. Insbesondere ist das zumindest eine Distanzelement mit einer Gehäuseinnenfläche verbunden. Unter anderem kann zumindest ein Distanzelement kegelförmig, quaderförmig oder zylinderförmig ausgestaltet sein. Durch zumindest ein derartiges Distanzelement wird das elektronische Bauelement gehalten, wodurch eine mechanische Stabilität während des Fügeprozesses, insbesondere vor dem Verbinden mit dem Substrat, erhöht wird.

Eine weitere Ausführungsform sieht vor, dass das Gehäuseelement eine verschließbare Öffnung zum Einfüllen des thermisch leitfähigen Füllmaterials, welches fließfähig ausgeführt ist, aufweist. Durch eine derartige Öffnung ist das Gehäuseelement besonders einfach befüllbar.

Eine weitere Ausführungsform sieht vor, dass das Gehäuseelement, insbesondere zumindest auf einer dem Substrat abgewandten Seite, Rippen aufweist. Durch derartige Rippen wird eine Gehäuseoberfläche zur Umgebung hin vergrößern und so eine verbesserte Entwärmung ermöglicht.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Anordnung,
- FIG 2: eine schematische Schnittdarstellung einer zweiten Ausführungsform einer Anordnung,
- FIG 3: eine schematische Schnittdarstellung einer dritten Ausführungsform einer Anordnung,
- FIG 4: eine schematische Schnittdarstellung einer vierten Ausführungsform einer Anordnung,
- FIG 5: eine schematische Darstellung eines Verfahrens zur Herstellung einer Anordnung,
- FIG 6: eine schematische Schnittdarstellung einer fünften Ausführungsform einer Anordnung,
- FIG 7: eine schematische Schnittdarstellung einer sechsten Ausführungsform einer Anordnung,
- FIG 8: eine schematische Darstellung von Segmentstreifen zur Herstellung von Gehäuseelementen für eine Anordnung,
- FIG 9: eine schematische Schnittdarstellung einer siebten Ausführungsform einer Anordnung,
- FIG 10: eine schematische Schnittdarstellung einer achten Ausführungsform einer Anordnung,
- FIG 11: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

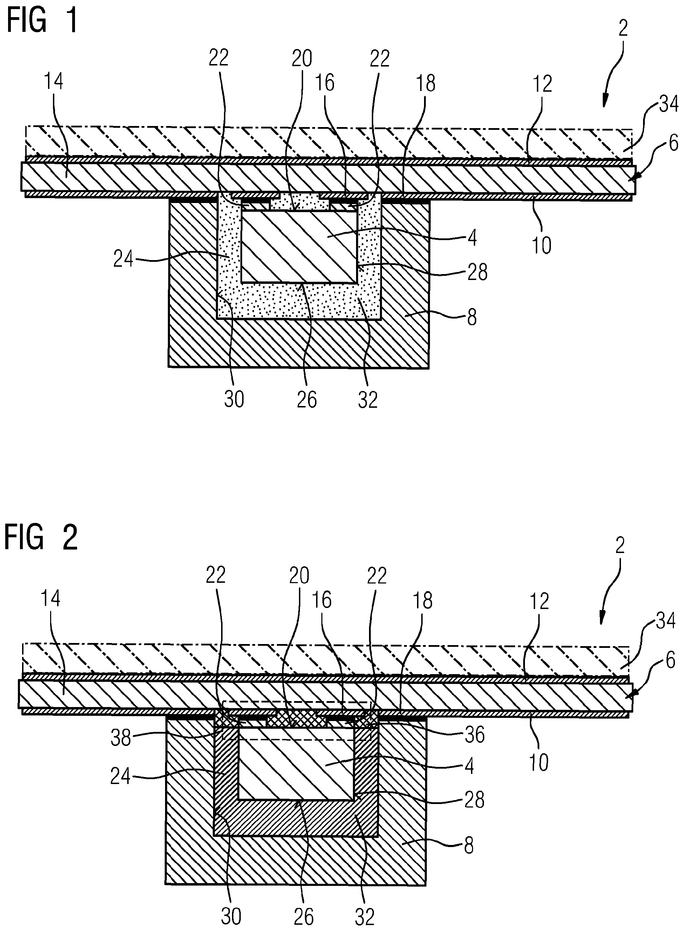

FIG 1 zeigt eine schematische Schnittdarstellung einer ersten Ausführungsform einer Anordnung 2, welche als Leistungsanordnung ausgeführt ist und ein elektronisches Bauelement 4, ein Substrat 6 sowie ein thermisch leitfähiges Gehäuseelement 8 umfasst. Das elektronische Bauelement 4 ist beispielhaft als lateraler Leistungshalbleiter, insbesondere mit breiter Bandlücke, ausgeführt sein. Derartige Leistungshalbleiter können beispielsweise in Siliziumcarbid- oder Galliumnitrid-Technologie realisiert sein. Alternativ kann das elektronische Bauelement 4 unter anderem als anderer Leistungshalbleiter, wie beispielsweise als IGBT oder vertikaler SiC-MOSFET, als Diode oder als passives Bauelement, z.B. als Shunt-Widerstand, ausgeführt sein. Das Substrat 6 weist auf einer dem elektronischen Bauelement 4 zugewandten Seite eine Metallisierung 10 und auf einer dem elektronischen Bauelement 4 abgewandten Seite eine weitere Metallisierung 12 auf. Die Metallisierungen sind über eine dielektrische Materiallage 14, welche beispielsweise Aluminiumoxid oder Aluminiumnitrid enthalten kann, mechanisch und thermisch leitend verbunden. Insbesondere ist das Substrat 6 als DCB (Direct Copper Bonded) Substrat ausgeführt. Die Metallisierung 10 umfasst eine erste Leiterstruktur 16 und eine von der ersten Leiterstruktur 16 elektrisch isoliert angeordnete zweite Leiterstruktur 18, wobei die erste Leiterstruktur 16 zumindest teilweise innerhalb der zweiten Leiterstruktur 18 angeordnet ist. Das elektronische Bauelement 4 weist auf einer Grundfläche 20 Kontaktierungselemente 22, beispielsweise Pins, auf, über welche das elektronische Bauelement 4 stoffschlüssig, beispielsweise über eine Löt- oder Sinterverbindung, mit der ersten Leiterstruktur 16 der Metallisierung 10 verbunden ist. Das als Leistungshalbleiter ausgeführte elektronische Bauelement 4 kann in einem Package oder *"*bare Die*"* mit dem Substrat 6 verbunden sein.

Das elektronische Bauelement 4 ist in dem thermisch leitfähigen Gehäuseelement 8 angeordnet und somit von diesem umgeben. Das thermisch leitfähigen Gehäuseelement 8 ist beispielsweise aus einem metallischen Werkstoff, z.B. Kupfer, Aluminium oder eine deren Legierungen, einem thermisch leitfähigen Kunststoff oder einem keramischen Werkstoff hergestellt. Ferner ist das Gehäuse 8 stoffschlüssig, beispielsweise adhäsiv, mit der zweiten Leiterstruktur 18 der Metallisierung 10 verbunden. Die adhäsive Verbindung wird mittels eines thermisch leitfähigen Klebers hergestellt. Ist das Gehäuse 8 zumindest im Bereich der Kontaktierung mit der Metallisierung 10 aus einem metallischen Werkstoff hergestellt, kann die stoffschlüssige Verbindung alternativ durch Löten oder Sintern hergestellt werden. Das elektronische Bauelement 4 wird durch das stoffschlüssige Verbinden des Gehäuseelements 8 mit der zweiten Leiterstruktur 16, insbesondere fluiddicht, gekapselt.

In dem thermisch leitfähigen Gehäuseelement 8 ist ein thermisch leitfähiges Füllmaterial 24 angeordnet. Das thermisch leitfähiges Füllmaterial 24, welches zumindest zum Zeitpunkt des Betriebs des elektronischen Bauelements 4 fließfähig ist, angeordnet. Das thermisch leitfähiges Füllmaterial 24 ist in FIG 1 als elektrisch isolierende Inertflüssigkeit ausgeführt. Beispiele für derartige Inertflüssigkeiten sind unter anderem Galden^{®} HS 240, 3M^{™} Novec^{™}, 3M^{™} Fluorinert^{™}. Zusätzlich oder alternativ kann das thermisch leitfähige Füllmaterial 24 ein Paraffin enthalten. Insbesondere weist das thermisch leitfähige Füllmaterial 24 eine Durchschlagsfestigkeit von mindestens 10 kV/mm auf. Das beispielsweise im Wesentlichen quaderförmig ausgeführte elektronische Bauelement 4 weist neben der Grundfläche 20 eine Deckfläche 26 und Seitenflächen 28 auf, wobei sowohl die Deckfläche 26 als auch die Seitenflächen 28 des elektronischen Bauelements 4 vollständig mit dem thermisch leitfähigen Füllmaterial 24 kontaktiert und über das thermisch leitfähige Füllmaterial 24 mit einer Gehäuseinnenwand 30 des Gehäuseelements 8 verbunden sind. Beispielhaft ist in FIG 1 ein Zwischenraum 32 zwischen dem elektronischen Bauelement 4 und dem Gehäuseelement 8 vollständig durch das thermisch leitfähige und elektrisch isolierende Füllmaterial 24 ausgefüllt. Auf diese Weise kann eine während des Betriebes des elektronischen Bauelements 4 entstehende Verlustwärme zusätzlich über das thermisch leitfähige Füllmaterial 24 und das thermisch leitfähige Gehäuseelement 8 an die Umgebung abgegeben werden. Zusätzlich kann die weitere Metallisierung 12 des Substrats 6 flächig mit einer Wärmesenke 34, insbesondere einen Kühlkörper verbunden sein. Die während des Betriebes des elektronischen Bauelements 4 entstehende Verlustwärme kann somit über das thermisch leitfähige Füllmaterial 24, das thermisch leitfähige Gehäuseelement 8 und das Substrat 6 an die flächig mit der weiteren Metallisierung 12 des Substrats 6 verbundene Wärmesenke 34 abgegeben werden.

FIG 2 zeigt eine schematische Schnittdarstellung einer zweiten Ausführungsform einer Anordnung 2, wobei das thermisch leitfähige Füllmaterial 24 elektrisch leitfähig ausgeführt ist. Beispielsweise wird als elektrisch und thermisch leitfähiges Füllmaterial 24 Flüssigmetall verwendet. Um Kurzschlüsse zu vermeiden ist das Füllmaterial 24 über einen elektrisch isolierenden Werkstoff 36 von einem Kontaktierungsbereich 38 des elektronischen Bauelements 4 mit dem Substrat 6 elektrisch isoliert angeordnet ist. Der elektrisch isolierenden Werkstoff 36 kann unter anderem Underfill, Kunststoff oder Silikon enthalten. Die weitere Ausführung der Anordnung 2 in FIG 2 entspricht der Ausführung in FIG 1.

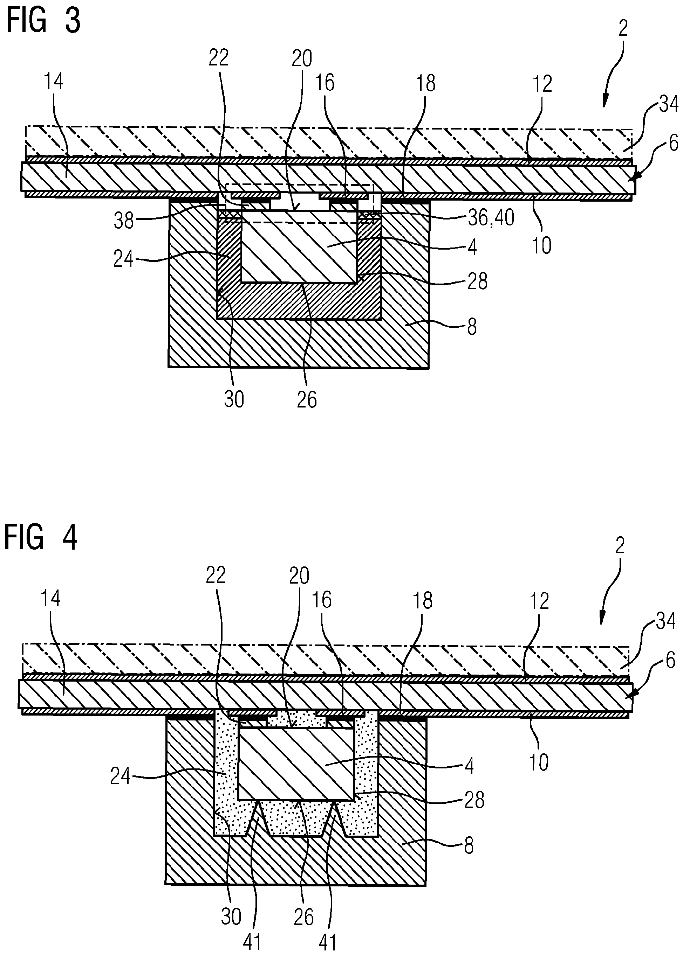

FIG 3 zeigt eine schematische Schnittdarstellung einer dritten Ausführungsform einer Anordnung 2. Ein elektrisch isolierender Werkstoff 36 ist als Abdichtelement 40 ausgeführt, welcher ein Kontaktieren des elektrisch und thermisch leitfähigen Füllmaterials 24, das zumindest zum Zeitpunkt des Betriebs des elektronischen Bauelements 4 fließfähig ist, mit den Kontaktierungselementen 22 des elektronischen Bauelements 4 verhindert. Beispielsweise ist das Abdichtelement 40, insbesondere adhäsiv, mit der Gehäuseinnenwand 30 und den Seitenflächen 28 des elektronischen Bauelements 4 verbunden. Das Füllmaterials 24 ist durch das Gehäuseelement 8 und das Abdichtelement 40 fluiddicht um das elektronische Bauelements 4 herum gekapselt. Die weitere Ausführung der Anordnung 2 in FIG 3 entspricht der Ausführung in FIG 2.

FIG 4 zeigt eine schematische Schnittdarstellung einer vierten Ausführungsform einer Anordnung 2, wobei das Gehäuseelement 8 auf der Gehäuseinnenwand 30 Distanzelemente 41 aufweist, welches mit dem elektronischen Bauelement 4 kontaktiert sind. Die Distanzelemente 41, welche beispielsweise kegelförmig oder alternativ quaderförmig oder zylinderförmig ausgestaltet sind, halten das elektronische Bauelement 4 und erhöhen die mechanische Stabilität während des Fügeprozesses, insbesondere vor dem Verbinden mit dem Substrat 6. Die weitere Ausführung der Anordnung 2 in FIG 4 entspricht der Ausführung in FIG 1.

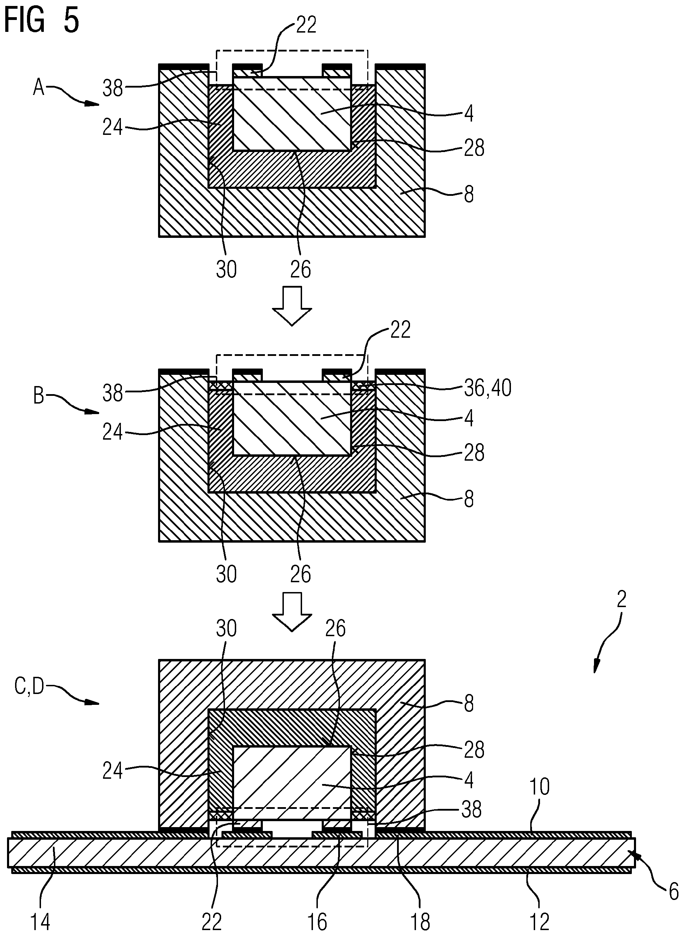

FIG 5 zeigt eine schematische Darstellung eines Verfahrens zur Herstellung einer Anordnung 2. Das Verfahren umfasst folgende Schritte:
Einlegen A eines elektronischen Bauelements 4 und eines thermisch leitfähigen Füllmaterials 24 in ein thermisch leitfähiges Gehäuseelement 8, wobei eine Deckfläche 26 und die Seitenflächen 28 des elektronischen Bauelements 4 über das thermisch leitfähige Füllmaterial 24 mit dem Gehäuseelement 8 verbunden werden. Das verwendete thermisch leitfähige Füllmaterial 24 ist elektrisch leitfähig ausgeführt und zumindest zum Zeitpunkt des Betriebs des elektronischen Bauelements 4 fließfähig. Beispielsweise wird als elektrisch und thermisch leitfähiges Füllmaterial 24 Flüssigmetall verwendet. Das elektronische Bauelements 4 wird derartig eingelegt, dass der Kontaktierungsbereich 38 des elektronischen Bauelements 4 mit den Kontaktierungselementen 22 nicht mit dem Flüssigmetall in Kontakt steht.

In einem weiteren Schritt erfolgt ein Abdichten B des Flüssigmetalls gegenüber dem Kontaktierungsbereich 38 des elektronischen Bauelements 4 mit einem Abdichtelement 40, das einen elektrisch isolierenden Werkstoff 36 enthält.

In einem weiteren Schritt erfolgt ein Verbinden C des elektronischen Bauelements 4 mit der ersten Leiterstruktur 16 der Metallisierung 10 des Substrats 6 und ein stoffschlüssiges Verbinden D des Gehäuseelements 8 mit der zweiten Leiterstruktur 18 der Metallisierung 10 des Substrats 6. Das Verbinden C und das stoffschlüssige Verbinden D kann durch Löten, Sintern oder adhäsiv, z.B. mittels eines elektrisch leitfähigen Klebers, erfolgen. Alternativ kann das Verbinden C des elektronischen Bauelements 4 durch Anpressen erfolgen. Zum Anpressen können beispielsweise elastische Verbindungselemente wie Federn oder Bügel verwendet werden. Die weitere Ausführung der Anordnung 2 in FIG 5 entspricht der Ausführung in FIG 3.

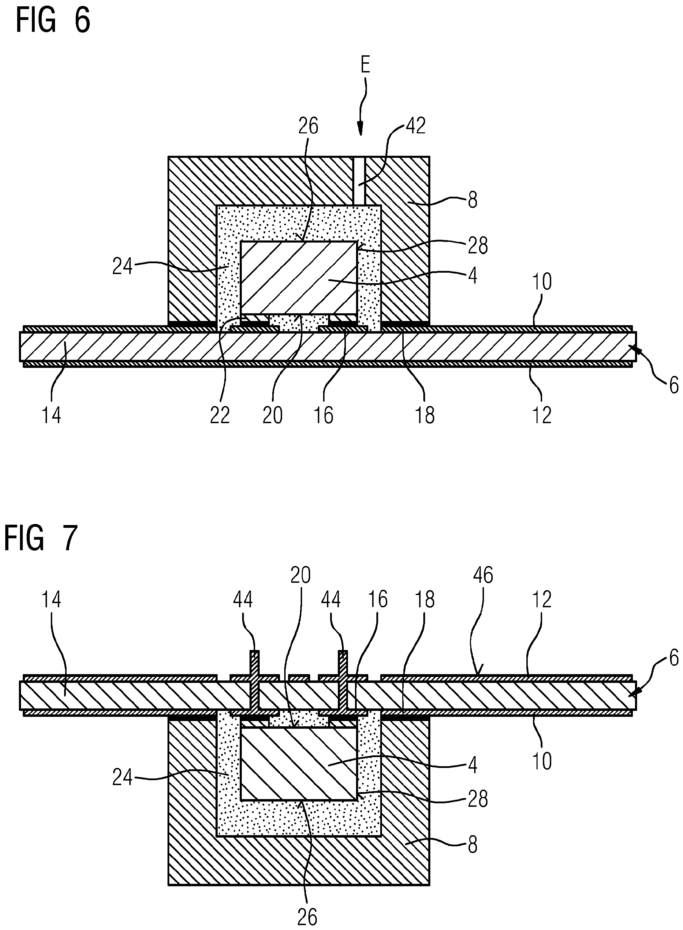

FIG 6 zeigt eine schematische Schnittdarstellung einer fünften Ausführungsform einer Anordnung 2, wobei ein Einfüllen E eines thermisch leitfähigen fließfähigen Füllmaterials 24 in das thermisch leitfähige Gehäuseelement 8 nach dem Verbinden C des elektronischen Bauelements 4 mit der ersten Leiterstruktur 16 und dem stoffschlüssigen Verbinden D des thermisch leitfähigen Gehäuseelements 8 mit der zweiten Leiterstruktur 18 über eine Öffnung 42 erfolgt. Nach dem Verschließen der Öffnung 42 ist das elektronische Bauelement 4, insbesondere fluiddicht, gekapselt. Die weitere Ausführung der Anordnung 2 in FIG 6 entspricht der Ausführung in FIG 1.

FIG 7 zeigt eine schematische Schnittdarstellung einer sechsten Ausführungsform einer Anordnung 2. Die erste Leiterstruktur 16 der Metallisierung 10 wird über Durchkontaktierungen 44 auf eine dem elektronischen Bauelement 4 abgewandte Seite 46 des Substrats 6 geführt. Die weitere Ausführung der Anordnung 2 in FIG 7 entspricht der Ausführung in FIG 1.

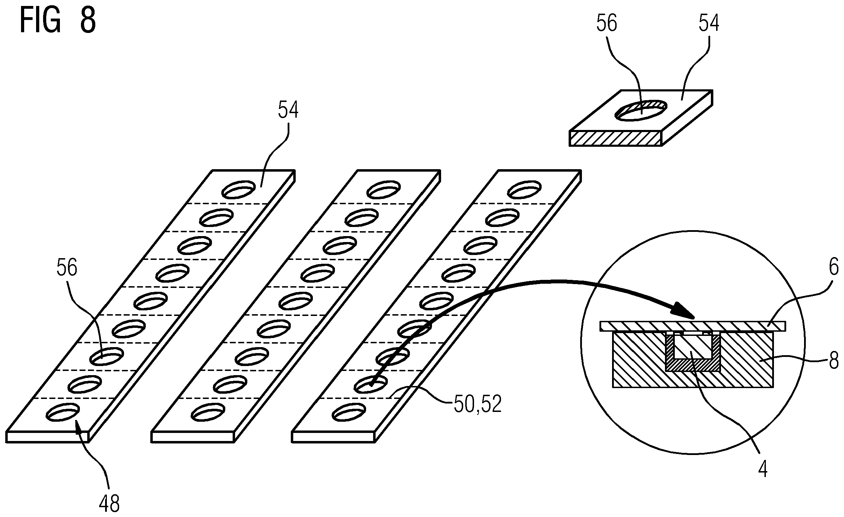

FIG 8 zeigt eine schematische Darstellung von, beispielsweise metallischen, Segmentstreifen 48 zur Herstellung von Gehäuseelementen 8 für eine Anordnung 2, wobei die Segmentstreifen 48 Sollbruchstellen 50, beispielsweise mit einer Perforierung 52, zur Herstellung von Gehäuseelementen 8 aus den Segmenten aufweisen. In den Segmenten 54 der Segmentstreifen 48 ist jeweils eine Kavität 56 zur Aufnahme eines elektronischen Bauelements 4 vorgesehen.

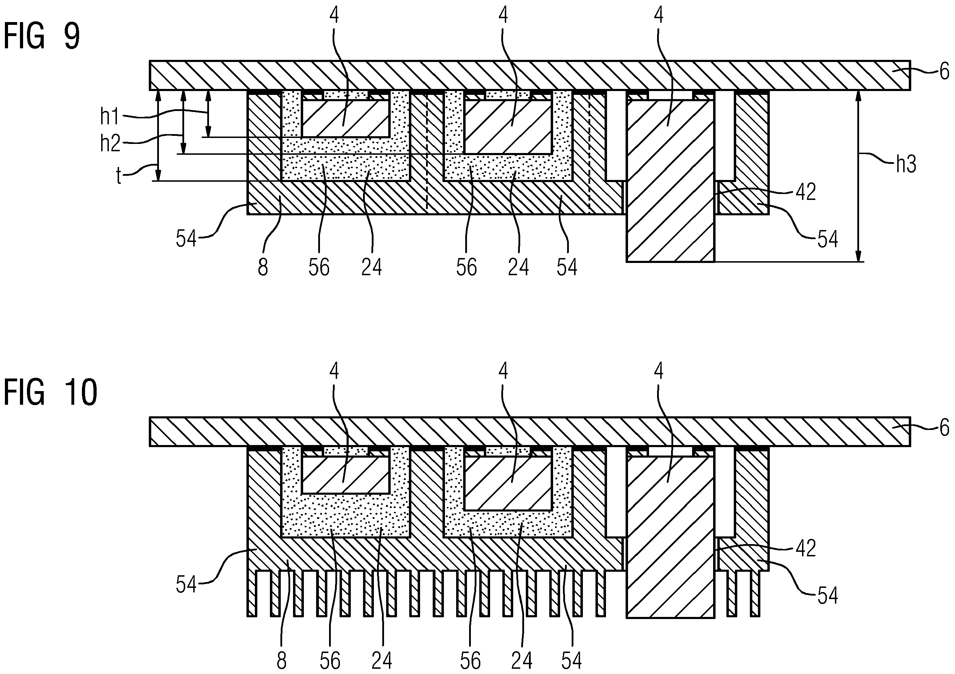

FIG 9 zeigt eine schematische Schnittdarstellung einer siebten Ausführungsform einer Anordnung 2, wobei das Gehäuseelement 8 aus beispielhaft drei Segmenten 54, welche jeweils eine Kavität 56 aufweisen, hergestellt ist. In den Kavitäten 56 sind elektronische Bauelemente 4 unterschiedlicher Höhen h1, h2, h3 angeordnet. Durch das thermisch leitfähige Füllmaterial 24 werden unterschiedliche Höhen h1, h2 der elektronischen Bauelemente 4, welche z.B. als Leistungshalbleiter ausgeführt sind, ausgeglichen solange die Höhe h1, h2 eine Tiefe t der Kavität 56 nicht überschreitet. Überschreitet ein elektronisches Bauteile 4, z.B. ein passives Bauelement wie ein Kondensator, mit einer Höhe h3 die Tiefe t der Kavität 56, kann eine Öffnung 42 eingefügt werden, sodass das elektronisches Bauteile 4 mit einer Höhe h3 über das Gehäuseelement 8 hinaussteht.

FIG 10 zeigt eine schematische Schnittdarstellung einer achten Ausführungsform einer Anordnung 2, wobei das Gehäuseelement 8 auf einer dem Substrat 6 abgewandten Seite Rippen 58 aufweist, welche die Gehäuseoberfläche zur Umgebung hin vergrößern und so eine verbesserte Entwärmung ermöglichen.

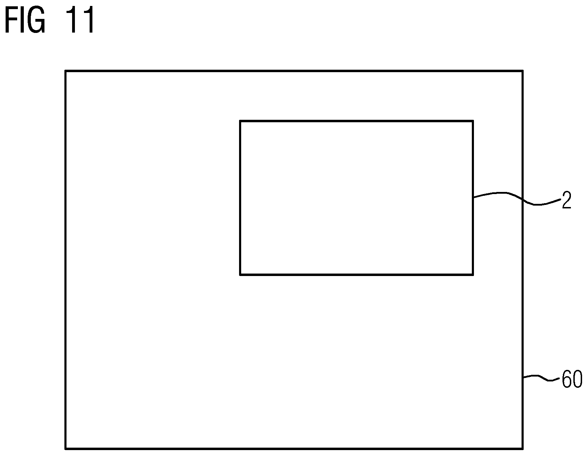

FIG 11 zeigt eine schematische Darstellung eines Stromrichters 60, welcher beispielsweise eine Anordnung 2 aufweist.

Zusammenfassend betrifft die Erfindung eine Anordnung 2 mit einem elektronischen Bauelement 4 und einem Substrat 6. Um den Bauraum einer derartigen Anordnung 2 zu verringern und eine verbesserte Entwärmung zu ermöglichen, wird vorgeschlagen, dass das Substrat 6 eine Metallisierung 10 mit zumindest einer ersten Leiterstruktur 16 und einer zweiten Leiterstruktur 18 aufweist, wobei die erste Leiterstruktur 16 zumindest teilweise innerhalb der zweiten Leiterstruktur 18 angeordnet ist, wobei das elektronische Bauelement 4, insbesondere stoffschlüssig, mit der ersten Leiterstruktur 16 verbunden ist, wobei das elektronische Bauelement 4 von einem thermisch leitfähigen Gehäuseelement 8 umgeben ist, welches stoffschlüssig mit der zweiten Leiterstruktur 18 verbunden ist, wobei eine Deckfläche 26 und zumindest eine Seitenfläche 28 des elektronischen Bauelements 4 über ein thermisch leitfähiges Füllmaterial 24 mit dem Gehäuseelement 8 verbunden ist.

## Patentansprüche

1. Anordnung (2) mit einem elektronischen Bauelement (4) und einem Substrat (6),
wobei das Substrat (6) eine Metallisierung (10) mit zumindest einer ersten Leiterstruktur (16) und einer zweiten Leiterstruktur (18) aufweist,
wobei die erste Leiterstruktur (16) zumindest teilweise innerhalb der zweiten Leiterstruktur (18) angeordnet ist,
wobei das elektronische Bauelement (4), insbesondere stoffschlüssig, mit der ersten Leiterstruktur (16) verbunden ist, wobei das elektronische Bauelement (4) von einem thermisch leitfähigen Gehäuseelement (8) umgeben ist, welches stoffschlüssig mit der zweiten Leiterstruktur (18) verbunden ist, wobei eine Deckfläche (26) und zumindest eine Seitenfläche (28) des elektronischen Bauelements (4) über ein thermisch leitfähiges Füllmaterial (24) mit dem Gehäuseelement (8) verbunden ist.

2. Anordnung (2) nach Anspruch 1,
wobei das thermisch leitfähige Füllmaterial (24) zumindest zum Zeitpunkt des Betriebs des elektronischen Bauelements (4) fließfähig ist.

3. Anordnung (2) nach einem der Ansprüche 1 oder 2,
wobei das elektronischen Bauelement (4) durch das Gehäuseelement (8), insbesondere fluiddicht, gekapselt ist.

4. Anordnung (2) nach einem der Ansprüche 1 bis 3,
wobei das thermisch leitfähige Füllmaterial (24) elektrisch isolierend ausgeführt ist.

5. Anordnung (2) nach Anspruch 4,
wobei ein Zwischenraum (32) zwischen dem elektronischen Bauelement (4) und dem Gehäuseelement (8) vollständig durch das thermisch leitfähige Füllmaterial (24) ausgefüllt ist.

6. Anordnung (2) nach einem der Ansprüche 1 bis 3,
wobei das thermisch leitfähige Füllmaterial (24) elektrisch leitfähig ausgeführt ist.

7. Anordnung (2) nach Anspruch 6,
wobei das Füllmaterial (24) über einen elektrisch isolierenden Werkstoff (36) von einem Kontaktierungsbereich (38) des elektronischen Bauelements (4) mit dem Substrat (6) elektrisch isoliert angeordnet ist.

8. Anordnung (2) nach Anspruch 7,
wobei der elektrisch isolierende Werkstoff (36) zumindest Teil eines Abdichtelements (40) ist.

9. Anordnung (2) nach einem der vorherigen Ansprüche,
wobei das Gehäuseelement (8) zumindest ein Distanzelement (41) aufweist, welches mit dem elektronischen Bauelement (4) kontaktiert ist.

10. Anordnung (2) nach einem der vorherigen Ansprüche,
wobei das Gehäuseelement (8) eine verschließbare Öffnung (42) zum Einfüllen (E) des thermisch leitfähigen Füllmaterials (24), welches fließfähig ausgeführt ist, aufweist.

11. Anordnung (2) nach einem der vorherigen Ansprüche,
wobei das Gehäuseelement (8), insbesondere zumindest auf einer dem Substrat (6) abgewandten Seite, Rippen (58) aufweist.

12. Stromrichter (60) mit mindestens einer Anordnung (2) nach einem der vorherigen Ansprüche.

13. Verfahren zur Herstellung einer Anordnung (2) mit einem elektronischen Bauelement (4) und einem Substrat (6),
wobei das Substrat (6) eine Metallisierung (10) mit zumindest einer ersten Leiterstruktur (16) und einer zweiten Leiterstruktur (18) aufweist,
wobei die erste Leiterstruktur (16) zumindest teilweise innerhalb der zweiten Leiterstruktur (18) angeordnet ist, umfassend folgende Schritte:
- Einlegen (A) des elektronischen Bauelements (4) und eines thermisch leitfähigen Füllmaterials (24) in ein thermisch leitfähiges Gehäuseelement (8),
wobei eine Deckfläche (26) und zumindest eine Seitenfläche (28) des elektronischen Bauelements (4) über das thermisch leitfähige Füllmaterial (24) mit dem Gehäuseelement (8) verbunden wird,
- Verbinden (C) des elektronischen Bauelements (4) mit der ersten Leiterstruktur (16) und
- stoffschlüssiges Verbinden (D) des Gehäuseelements (8) mit der zweiten Leiterstruktur (18).

14. Verfahren nach Anspruch 13,
wobei ein thermisch leitfähiges Füllmaterial (24) verwendet wird, welches zumindest zum Zeitpunkt des Betriebs des elektronischen Bauelements (4) fließfähig ist.

15. Verfahren nach einem der Ansprüche 13 oder 14,
wobei das elektronische Bauelement (4) durch das stoffschlüssige Verbinden (D) des Gehäuseelements (8) mit der zweiten Leiterstruktur (18), insbesondere fluiddicht, gekapselt wird.

16. Verfahren nach einem der Ansprüche 13 bis 15,
wobei das thermisch leitfähige Füllmaterial (24) elektrisch leitfähig ausgeführt ist,
wobei das Füllmaterial (24) über einen elektrisch isolierenden Werkstoff (36) von einem Kontaktierungsbereich (38) des elektronischen Bauelements (4) mit dem Substrat (6) elektrisch isoliert angeordnet wird.

17. Verfahren nach einem der Ansprüche 13 bis 16,
wobei nach dem Einlegen (A) ein Abdichten (B) des Füllmaterials (24) gegenüber einem Kontaktierungsbereich (38) des elektronischen Bauelements (4) erfolgt.

18. Verfahren zur Herstellung einer Anordnung (2) mit einem elektronischen Bauelement (4) und einem Substrat (6),
wobei das Substrat (6) eine Metallisierung (10) mit zumindest einer ersten Leiterstruktur (16) und einer zweiten Leiterstruktur (18) aufweist,
wobei die erste Leiterstruktur (16) zumindest teilweise innerhalb der zweiten Leiterstruktur (18) angeordnet ist, umfassend folgende Schritte:
- Verbinden (C) des elektronischen Bauelements (4) mit der ersten Leiterstruktur (16) und
- stoffschlüssiges Verbinden (D) eines thermisch leitfähigen Gehäuseelements (8) mit der zweiten Leiterstruktur (18),
- Einfüllen (E) eines thermisch leitfähigen fließfähigen Füllmaterials (24) in das Gehäuseelement (8),
wobei eine Deckfläche (26) und zumindest eine Seitenfläche (28) des elektronischen Bauelements (4) über das Füllmaterial (24) mit dem Gehäuseelement (8) verbunden wird.

19. Verwendung von, insbesondere metallischen, Segmentstreifen (48) mit Segmenten (54), welche jeweils eine Kavität (56) aufweisen, zur Herstellung von Gehäuseelementen (8) für eine Anordnung (2) nach einem der Ansprüche 1 bis 11,
wobei die Segmentstreifen (48) zwischen den Segmenten (54) Sollbruchstellen (50), insbesondere mit einer Perforierung (52), aufweisen.
